# EUROPEAN PATENT APPLICATION

(11) **EP 2 600 408 A1**
(43) Date of publication of application: **05.06.2013**
(21) Application number: 11812144.1
(22) Date of filing: 16.05.2011
(51) Int. Cl.: H01L 31/04

(54) **THIN FILM SOLAR CELL AND MANUFACTURING METHOD THEREOF**

(30) Priority: 28.07.2010 JP 2010169106
(71) Applicant: Fuji Electric Co., Ltd., Kawasaki-shi 210-9530 (JP)
(72) Inventor: MASUDA, Nobuyuki, Kawasaki-shi Kanagawa 210-9530 (JP)
(74) Representative: MERH-IP Matias Erny Reichl Hoffmann
(86) International application number: PCT/JP2011/061144
(87) International publication number: WO 2012/014549

(57) **Abstract**

A thin-film photovoltaic cell 10, wherein a serially connected structure is formed by plural unit photovoltaic cells, wherein a first electrode layer 1b, a semiconductor layer 1f, and a third electrode layer 1g are formed on a main surface of an insulating substrate 1a, a second electrode layer 1c and a fourth electrode layer 1i are formed on another surface of the substrate 1a, and the third electrode layer 1g is connected to the second electrode layer 1c and fourth electrode layer 1i, by a conductor isolated from the first electrode layer 1b, via second through holes h2 that penetrate the substrate 1a, first electrode layer 1b, second electrode layer 1c, and semiconductor layer 1f, being formed with the substrate 1a in common, adjacent unit photovoltaic cells being electrically isolated by a main surface side processed portion in which the first electrode layer 1b, semiconductor layer 1f, and third electrode layer 1g are removed, and by an other surface side processed portion in which the second electrode layer 1c and fourth electrode layer 1i are removed, and an extension portion of the first electrode layer 1b of one unit photovoltaic cell being connected to an extension portion of the second electrode layer 1c of an adjacent unit photovoltaic cell, by a conductor isolated from the third electrode layer 1g of the unit photovoltaic cell, via one or more first through holes h1 that penetrate the substrate 1a, wherein acceleration and deceleration regions for forming a crooked structure of the other surface side processed portion, or intersection portions of processing lines P3 configuring the crooked structure, are disposed in locally electrically isolated regions in the first electrode layer 1b before the formation of the semiconductor layer 1f.

## Description

### Technical Field

The present invention relates to a thin-film photovoltaic cell and manufacturing method thereof wherein a material typified by amorphous silicon, microcrystal silicon, or the like, is used in a photoelectric conversion layer.

### Background Art

At present, research and development into clean energy is proceeding with a view to environment protection. Above all, photovoltaic cells are attracting attention for having advantages such as their source (solar light) being infinite, and their being nonpolluting.
Photovoltaic cells in which amorphous silicon or microcrystal silicon, a compound such as CdTe or CIGS, or an organic material is used in a photoelectric conversion layer, unlike existing crystalline silicon or polycrystalline silicon photovoltaic cells, can be formed on various kinds of substrate. For example, in Patent Document 1, an example is shown wherein amorphous silicon is employed as a photoelectric conversion element on a polymer film, adding extra values of lightness and flexibility to a photovoltaic cell.

Meanwhile, as the voltage generated by a single photovoltaic cell is too low, generally structures are adopted wherein voltage generated is increased by connecting plural single photovoltaic cells in series. Of these, it is thought that thin-film photovoltaic cells, owing to their thinness and lightness, low manufacturing cost, and the fact that their area can be easily increased, will become the mainstream photovoltaic cells of the future.
With a thin-film photovoltaic cell, it is often the case that a serially connected structure is realized by forming a photoelectric conversion layer on one substrate, and dividing it into a plurality using a laser patterning, or the like. Laser not being the only means of carrying out a patterning, it can also be carried out using, for example, an ultrasonic transducer, sandblasting, or the like. In the case of a thin-film photovoltaic cell having a serially connected structure, voltage generated is proportional to the number of series stages and current to the area of a single photovoltaic cell, meaning that the greater the number of series stages and the larger the area of a single photovoltaic cell, the greater the output generated. In Patent Document 1, there is shown, as one example of a serially connected structure, an example wherein plural two kinds of connection hole with differing functions are opened in an insulating polymer film, forming a series connection.

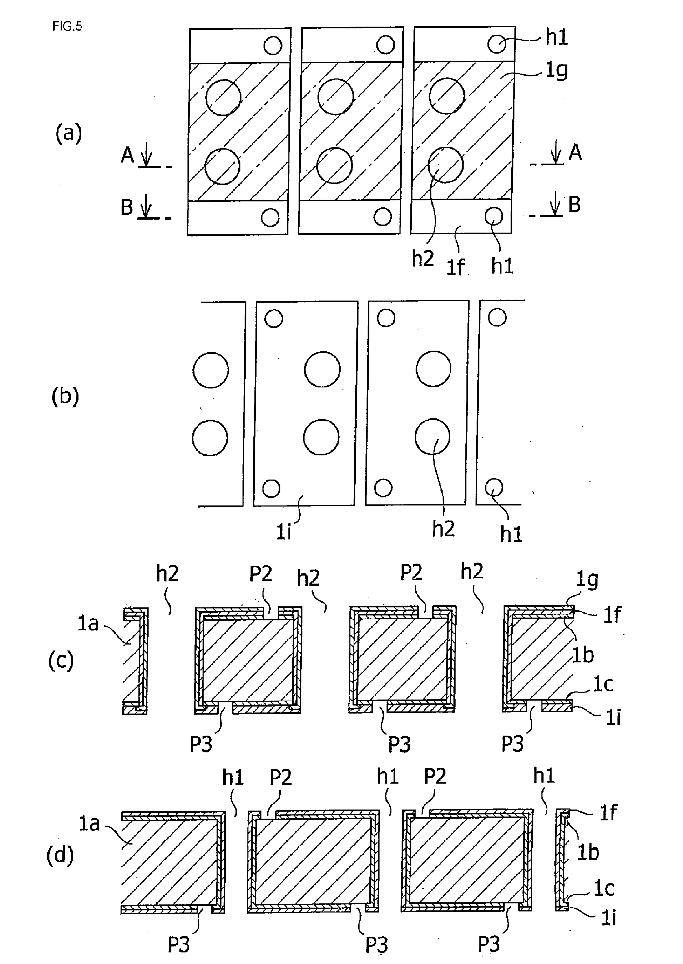

Figs. 5 (a) to (d) are diagrams representing one example of a heretofore known thin-film photovoltaic cell structure, wherein (a) is a plan view seen from a light receiving surface (main surface) side, (b) is a plan view seen from another surface side, and (c) and (d) are sectional views along an A-A line and B-B line of (a) respectively. In order to manufacture a thin-film photovoltaic cell with this kind of structure, firstly, plural first through holes (connection holes) h1 for connecting a first electrode layer 1b and second electrode layer 1c are opened in predetermined positions in a substrate 1a, and next, the first electrode layer 1b is formed on a main surface side of the substrate 1a, and the second electrode layer 1c is formed on another surface side. Subsequently, plural second through holes (current collection holes) h2 for connecting a third electrode layer 1g to the second electrode layer 1c and a fourth electrode layer 1i are opened, and next, a semiconductor layer 1f, which forms a main surface side photoelectric conversion layer, and the third electrode layer 1g, which is a transparent electrode, are formed sequentially on the first electrode layer 1b formed on the main surface side.
When forming the second electrode layer 1c, a region in which the third electrode layer 1g is not formed is formed using a method such as applying a mask, or the like, in the periphery of the first through holes h1, preventing adherence of the third electrode layer 1g. In (a), hatching is drawn in regions in which the third electrode layer 1g is formed.

Next, the fourth electrode layer 1i, formed from a low resistance conductive film such as a metal film, is deposited on the other surface side. Because of this, the third electrode layer 1g and fourth electrode layer 1i are stacked, and it is possible to cause them to be mutually conductive. As a result of this, the first electrode layer 1b is connected to the second electrode layer 1c and fourth electrode layer 1i via the first through holes h1, and the third electrode layer 1g and the second electrode layer 1c and fourth electrode layer 1i are connected via the second through holes h2. The three layers - the third electrode layer 1g, photoelectric conversion layer 1f, and first electrode layer 1b - of the main surface side of the thin-film photovoltaic cell stacked in this way are divided into strip forms by forming parting lines (removal portions) P2 in a linear form using a laser patterning, or the like, after which, the second electrode layer 1c and fourth electrode layer 1i are divided, in the same way as previously described, into strip forms by forming parting lines (removal portions) P3 in a linear form. By so doing, serially connected photovoltaic cell sub-modules are formed.

When the thin-film photovoltaic cell with the heretofore described structure is irradiated with light, and carriers (electrons in an n-type semiconductor and holes in a p-type semiconductor) are generated inside the photoelectric conversion layer 1f of the unit photovoltaic cells divided into strip form, some carriers flow to the second electrode layer 1c owing to an electric field inside the p-n junction. As the third electrode layer 1g has continuity with the second electrode layer 1c and fourth electrode layer 1i of the other surface side on the wall surfaces of the second through holes h2, the carriers move to the rear side of the substrate 1a via the second through holes h2. Herein, as it is possible to consider the photoelectric conversion layer 1f to be essentially an insulation layer, the third electrode layer 1g and first electrode layer 1b are essentially isolated. The carriers reaching the rear side of the substrate 1a continue moving as far as the connection holes h1, which are the first through holes, at either side of the drawing. As the third electrode layer 1g is not formed in the connection hole h1 portions, and the first electrode layer 1b, second electrode layer 1c, and fourth electrode layer 1i have continuity on the wall surfaces of the connection holes h1, the carriers move again from the substrate 1a to the light receiving surface side via the connection holes h1. Subsequently, the carriers move to the photoelectric conversion layer 1f (the semiconductor layer) in an adjacent unit photovoltaic cell on the light receiving surface side. In this way, the structure is such that adjacent unit photovoltaic cells are serially connected via the second through holes h2 and connection holes h1.

In the heretofore described example, the patterning lines on the light receiving surface side and rear side of the substrate are of a linear form, but it is not necessary that the patterning lines are always of a linear form. As one example, in Patent Document 1, there is shown a structure wherein the patterning lines on the light receiving surface side are of a linear form, but the patterning lines on the rear side bend partway along. In the case of a bent pattern, a two-dimensional sweep in the laser X-Y direction is necessary in the bent portion. In this case, in order to reliably form the processing line in accordance with the dimensions when changing the direction of movement of a laser that has been proceeding one-dimensionally in the X direction to a two-dimensional X-Y direction, there arises a need to temporarily decelerate the laser's rate of advancement, and change the laser's direction of movement.

The processing of the patterning lines is such that, when exerting more force than necessary in order to remove by applying a thermal or mechanical force to the processed portion, it may happen that damage is caused to a portion peripheral to the line or to an element on the opposite side of the substrate. In the case of a processing using a laser, the structure is such that a pulse-like irradiation is carried out at a constant frequency, removing a member in the irradiated portion, meaning that, when carrying out a pulse irradiation in the same place a certain number of times or more, there is a possibility of causing damage in the periphery of that portion. This kind of situation mainly occurs in a laser acceleration or deceleration region, such as in the vicinity of a laser processing starting point or finishing point position, and in Patent Document 2, there is provided a method whereby a shutter or mask is disposed between a laser emission portion and a processed portion, blocking the laser irradiation of the processed portion in the acceleration and deceleration regions.

### Related Art Documents

### Patent Documents

Patent Document 1: JP-A-6-342924
Patent Document 2: JP-A-11-204815
Patent Document 3: JP-A-8-56005

### Outline of the Invention

### Problems that the Invention is to Solve

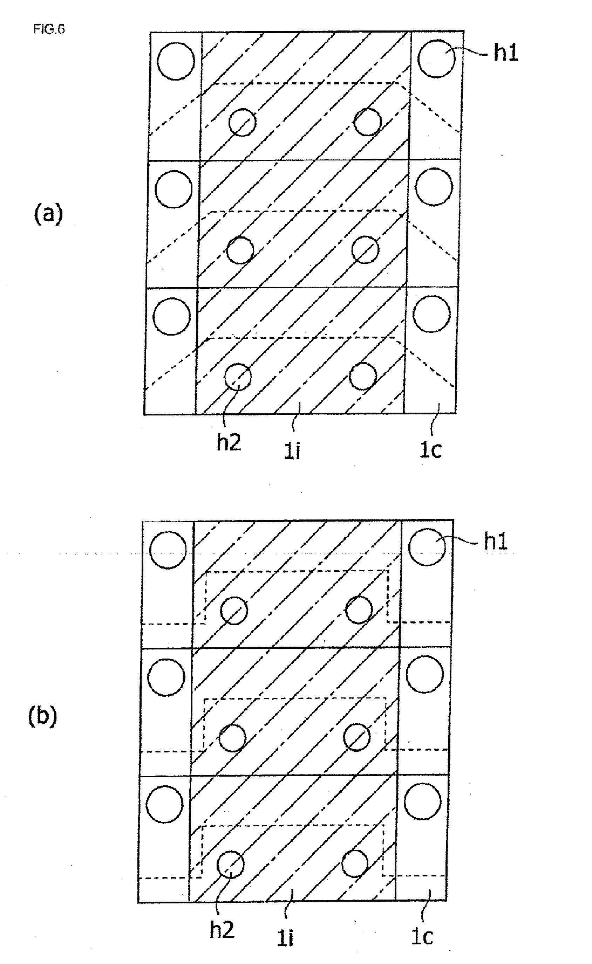

However, with the structure of the thin-film photovoltaic cell disclosed in Patent Document 1, when the second electrode layer 1c and fourth electrode layer (photoelectric conversion layer) 1i of the other surface side are processed into the kind of crooked structure indicated by broken lines in Fig. 6(a), there arise acceleration and deceleration regions for temporarily decelerating the laser's rate of advancement, and changing the laser's direction of movement, in order to process accurately, meaning that there is a problem in that the main surface side first electrode layer 1b and the fourth electrode layer 1i are damaged, and a leak occurs. Also, when the second electrode layer 1c and fourth electrode layer 1i of the other surface side are processed into the kind of structure indicated by broken lines in Fig. 6(b) wherein plural straight lines are caused to intersect, the same kind of damage and leak as heretofore described occur in a laser acceleration and deceleration region and intersection portion of each straight line.
This is because overlapping laser pulses increase in regions that are patterning acceleration or deceleration regions and in regions that form intersections, and laser energy that penetrates the substrate 1a falls incident on the first electrode layer 1b and fourth electrode layer 1f, meaning that destruction of photoelectric conversion element portions of the first electrode layer 1b and fourth electrode layer 1f or crystallization of the photoelectric conversion element portions occurs, and the first electrode layer 1b and third electrode layer 1g have continuity.
Also, with the method whereby the laser is blocked in the laser acceleration and deceleration regions using a shutter, or the like, as well as leading to an increase in the cost of the laser processing device, the switching speed of the shutter cannot sufficiently keep pace with the laser oscillation frequency, and it is difficult to process with good control.
With a method other than laser too, for example, processing using an ultrasonic transducer or sandblasting, as excessive force or energy is exerted on the elements in the acceleration and deceleration regions in comparison with in other portions, the same kind of problem as with the laser processing occurs.

Also, in Patent Document 3, there are presented, as thin-film photovoltaic cell manufacturing methods that do not damage the layers on the other surface, using a short wavelength laser beam that essentially does not penetrate the polymer substrate for the process of dividing the third electrode layer or, in order to prevent energy from reaching the layers formed on the other surface when carrying out the process of dividing the layers on one surface, using a thick substrate in the case of a material with high transmittance with respect to a laser beam, thus lowering the processing output of the laser beam.
However, with the manufacturing methods disclosed in Patent Document 3, as well as the cost of the laser oscillator rising, the substrate itself is processed, there is a possibility of long-term reliability, and the like, decreasing, the cost rises due to material costs when thickening the substrate, and processing becomes impossible with some electrode layer materials when lowering the processing output of the laser beam.

An object of the invention, in order to solve these kinds of problems with the heretofore known technology, is to provide a highly efficient thin-film photovoltaic cell, and manufacturing method thereof, with which it is possible to change output voltage and current in accordance with needs, without reducing mass productivity.

### Means for Solving the Problems

In order to solve the heretofore described problems with the heretofore known technology, the invention is a thin-film photovoltaic cell, wherein a serially connected structure is formed by plural unit photovoltaic cells, wherein a first electrode layer, a semiconductor layer that is a photoelectric conversion layer, and a transparent third electrode layer are sequentially stacked on a main surface of an insulating substrate, a second electrode layer and a fourth electrode layer are formed on another surface of the substrate, and the third electrode layer is connected to the second electrode layer and fourth electrode layer, by a conductor essentially isolated from the first electrode layer, via one or more second through holes that penetrate the substrate, first electrode layer, second electrode layer, and semiconductor layer, being formed on a common substrate, adjacent unit photovoltaic cells being electrically isolated by a main surface side processed portion in which the first electrode layer, semiconductor layer, and third electrode layer are removed, and by an other surface side processed portion in which the second electrode layer and fourth electrode layer are removed, and an extension portion of the first electrode layer of one unit photovoltaic cell being connected to an extension portion of the second electrode layer of an adjacent unit photovoltaic cell, by a conductor essentially isolated from the third electrode layer of the unit photovoltaic cell, via one or more first through holes that penetrate the substrate, wherein the other surface side processed portion has a crooked structure, and acceleration and deceleration regions for forming the crooked structure of the other surface side processed portion, or intersection portions of processing lines configuring the crooked structure, are disposed in locally electrically isolated regions in the first electrode layer before the formation of the semiconductor layer.

Also, the invention is a thin-film photovoltaic cell, wherein a serially connected structure is formed by plural unit photovoltaic cells, wherein a first electrode layer, a semiconductor layer that is a photoelectric conversion layer, and a transparent third electrode layer are sequentially stacked on a main surface of an insulating substrate, a second electrode layer and a fourth electrode layer are formed on another surface of the substrate, and the third electrode layer is connected to the second electrode layer and fourth electrode layer, by a conductor essentially isolated from the first electrode layer, via one or more second through holes that penetrate the substrate, first electrode layer, second electrode layer, and semiconductor layer, being formed on a common substrate, adjacent unit photovoltaic cells being electrically isolated by a main surface side processed portion in which the first electrode layer, semiconductor layer, and third electrode layer are removed, and by an other surface side processed portion in which the second electrode layer and fourth electrode layer are removed, and an extension portion of the first electrode layer of one unit photovoltaic cell being connected to an extension portion of the second electrode layer of an adjacent unit photovoltaic cell, by a conductor essentially isolated from the third electrode layer of the unit photovoltaic cell, via one or more first through holes that penetrate the substrate, wherein the other surface side processed portion has a crooked structure, and acceleration and deceleration regions for forming the crooked structure of the other surface side processed portion, or intersection portions of processing lines configuring the crooked structure, are disposed in locally electrically isolated regions from which the first electrode layer, semiconductor layer, and third electrode layer are removed.

It is preferable that the thin-film photovoltaic cell of the invention is configured in the following way.
That is, in the invention, the processing lines have a form such that they are bent twice at 90° in places corresponding to the electrically isolated regions in the first electrode layer.
Also, in the invention, the processing lines have a form such that they are slanted at an obtuse angle in places corresponding to the electrically isolated regions in the first electrode layer.

Then, the invention is a thin-film photovoltaic cell manufacturing method, whereby a serially connected structure is formed by plural unit photovoltaic cells, wherein a first electrode layer, a semiconductor layer that is a photoelectric conversion layer, and a transparent third electrode layer are sequentially stacked on a main surface of an insulating substrate, a second electrode layer and a fourth electrode layer are formed on another surface of the substrate, and the third electrode layer is connected to the second electrode layer and fourth electrode layer, by a conductor essentially isolated from the first electrode layer, via one or more second through holes that penetrate the substrate, first electrode layer, second electrode layer, and semiconductor layer, being formed on a common substrate, adjacent unit photovoltaic cells being electrically isolated by a main surface side processed portion in which the first electrode layer, semiconductor layer, and third electrode layer are removed, and by an other surface side processed portion in which the second electrode layer and fourth electrode layer are removed, and an extension portion of the first electrode layer of one unit photovoltaic cell being connected to an extension portion of the second electrode layer of an adjacent unit photovoltaic cell, by a conductor essentially isolated from the third electrode layer of the unit photovoltaic cell, via one or more first through holes that penetrate the substrate, wherein, before the semiconductor layer is formed on the first electrode layer, locally electrically isolated regions are formed in the first electrode layer by removing the first electrode layer, after which, the main surface side processed portion is formed by removing the first electrode layer, semiconductor layer, and third electrode layer, the other surface side processed portion is formed by removing the second electrode layer and fourth electrode layer, and acceleration and deceleration regions for forming a crooked structure of the other surface side processed portion, or intersection portions of processing lines configuring the crooked structure, are disposed in the electrically isolated regions.

Also, the invention is a thin-film photovoltaic cell manufacturing method, whereby a serially connected structure is formed by plural unit photovoltaic cells, wherein a first electrode layer, a semiconductor layer that is a photoelectric conversion layer, and a transparent third electrode layer are sequentially stacked on a main surface of an insulating substrate, a second electrode layer and a fourth electrode layer are formed on another surface of the substrate, and the third electrode layer is connected to the second electrode layer and fourth electrode layer, by a conductor essentially isolated from the first electrode layer, via one or more second through holes that penetrate the substrate, first electrode layer, second electrode layer, and semiconductor layer, being formed on a common substrate, adjacent unit photovoltaic cells being electrically isolated by a main surface side processed portion in which the first electrode layer, semiconductor layer, and third electrode layer are removed, and by an other surface side processed portion in which the second electrode layer and fourth electrode layer are removed, and an extension portion of the first electrode layer of one unit photovoltaic cell being connected to an extension portion of the second electrode layer of an adjacent unit photovoltaic cell, by a conductor essentially isolated from the third electrode layer of the unit photovoltaic cell, via one or more first through holes that penetrate the substrate, wherein, after stacking the semiconductor layer and third electrode layer, and forming the other surface side processed portion by removing the second electrode layer and fourth electrode layer, there are formed regions locally electrically isolated by the main surface side processed portion from which the first electrode layer, semiconductor layer, and third electrode layer are removed, and acceleration and deceleration regions for forming a crooked structure of the other surface side processed portion, or intersection portions of processing lines configuring the crooked structure, are disposed in the electrically isolated regions.

With the thin-film photovoltaic cell manufacturing method of the invention, it is preferable that the processing lines have a form such that they are bent twice at 90° in places corresponding to the electrically isolated regions in the first electrode layer.
Also, with the thin-film photovoltaic cell manufacturing method of the invention, it is preferable that the processing lines have a form such that they are slanted at an obtuse angle in places corresponding to the electrically isolated regions in the first electrode layer.

### Advantage of the Invention

As heretofore described, the thin-filmphotovoltaic cell according to the invention is such that a serially connected structure is formed by plural unit photovoltaic cells, wherein a first electrode layer, a semiconductor layer that is a photoelectric conversion layer, and a transparent third electrode layer are sequentially stacked on a main surface of an insulating substrate, a second electrode layer and a fourth electrode layer are formed on another surface of the substrate, and the third electrode layer is connected to the second electrode layer and fourth electrode layer, by a conductor essentially isolated from the first electrode layer, via one or more second through holes that penetrate the substrate, first electrode layer, second electrode layer, and semiconductor layer, being formed on a common substrate, adjacent unit photovoltaic cells being electrically isolated by a main surface side processed portion in which the first electrode layer, semiconductor layer, and third electrode layer are removed, and by an other surface side processed portion in which the second electrode layer and fourth electrode layer are removed, and an extension portion of the first electrode layer of one unit photovoltaic cell being connected to an extension portion of the second electrode layer of an adjacent unit photovoltaic cell, by a conductor essentially isolated from the third electrode layer of the unit photovoltaic cell, via one or more first through holes that penetrate the substrate, wherein the other surface side processed portion has a crooked structure, and acceleration and deceleration regions for forming the crooked structure of the other surface side processed portion, or intersection portions of processing lines configuring the crooked structure, are disposed in locally electrically isolated regions in the first electrode layer before the formation of the semiconductor layer, meaning that, even when crystallization or damage occurs due to a laser processing, or the like, in the formation of the crooked structure of the other surface side processed portion, it does not happen that a leak path is formed due to the first electrode layer and second electrode layer becoming continuous.
Consequently, according to the invention, as it is possible to selectively change the output voltage and current of the thin-film photovoltaic cell without reducing the output voltage, current, and mass productivity, it is possible to provide a highly efficient thin-film photovoltaic cell having the required output voltage and current at a low price.

Also, the invention is such that, in the thin-film photovoltaic cell with the heretofore described configuration, the other surface side processed portion has a crooked structure, and acceleration and deceleration regions for forming the crooked structure of the other surface side processed portion, or intersection portions of processing lines configuring the crooked structure, are disposed in locally electrically isolated regions from which the first electrode layer, semiconductor layer, and third electrode layer are removed, meaning that it is possible to obtain the same advantages as with the previously described invention, and the invention has superior quality as a thin-film photovoltaic cell.

Furthermore, the thin-film photovoltaic cell manufacturing method according to the invention is such that a serially connected structure is formed by plural unit photovoltaic cells, wherein a first electrode layer, a semiconductor layer that is a photoelectric conversion layer, and a transparent third electrode layer are sequentially stacked on a main surface of an insulating substrate, a second electrode layer and a fourth electrode layer are formed on another surface of the substrate, and the third electrode layer is connected to the second electrode layer and fourth electrode layer, by a conductor essentially isolated from the first electrode layer, via one or more second through holes that penetrate the substrate, first electrode layer, second electrode layer, and semiconductor layer, being formed on a common substrate, adjacent unit photovoltaic cells being electrically isolated by a main surface side processed portion in which the first electrode layer, semiconductor layer, and third electrode layer are removed, and by an other surface side processed portion in which the second electrode layer and fourth electrode layer are removed, and an extension portion of the first electrode layer of one unit photovoltaic cell being connected to an extension portion of the second electrode layer of an adjacent unit photovoltaic cell, by a conductor essentially isolated from the third electrode layer of the unit photovoltaic cell, via one or more first through holes that penetrate the substrate, wherein, after stacking the semiconductor layer and third electrode layer, and forming the other surface side processed portion by removing the second electrode layer and fourth electrode layer, there are formed regions locally electrically isolated by the main surface side processed portion from which the first electrode layer, semiconductor layer, and third electrode layer are removed, and acceleration and deceleration regions for forming a crooked structure of the other surface side processed portion, or intersection portions of processing lines configuring the crooked structure, are disposed in the electrically isolated regions, meaning that it is possible to easily manufacture a highly efficient thin-film photovoltaic cell having the required output voltage and current, and thus possible to respond to a variety of needs.

Also, the invention, manufacturing the thin-film photovoltaic cell with the heretofore described configuration, is such that, after stacking the semiconductor layer and third electrode layer, and forming the other surface side processed portion by removing the second electrode layer and fourth electrode layer, there are formed regions locally electrically isolated by the main surface side processed portion from which the first electrode layer, semiconductor layer, and third electrode layer are removed, and acceleration and deceleration regions for forming a crooked structure of the other surface side processed portion, or intersection portions of processing lines configuring the crooked structure, are disposed in the electrically isolated regions, meaning that it is possible to obtain the same advantages as with the previously described invention, and thus possible to manufacture a high quality thin-film photovoltaic cell.

### Brief Description of the Drawings

[Fig. 1] Fig. 1 is a plan view showing a thin-film photovoltaic cell structure according to embodiments of the invention.
[Fig. 2] Fig. 2 shows sectional views along an X-X line in Fig. 1, wherein (a) to (i) are schematic sectional views of manufacturing steps of a thin-film photovoltaic cell according to a first embodiment of the invention.
[Fig. 3] Fig. 3 shows sectional views along the X-X line in Fig. 1, wherein (a) to (i) are schematic sectional views of manufacturing steps of a thin-film photovoltaic cell according to a second embodiment of the invention.
[Fig. 4] Fig. 4 is a plan view showing a bent patterning structure of a thin-film photovoltaic cell according to a modification example of the embodiments of the invention.
[Fig. 5] Fig. 5 shows a heretofore known thin-film photovoltaic cell structure, wherein (a) is a plan view seen from a main surface side, (b) is a plan view seen from another surface side, (c) is a sectional view along an A-A line of (a), and (d) is a sectional view along a B-B line of (a).
[Fig. 6] Figs. 6(a) and (b) are plan views showing an example of a bent patterning structure of a heretofore known thin-film photovoltaic cell.

### Modes for Carrying Out the Invention

Hereafter, a detailed description will be given, while referring to the drawings, of a thin-film photovoltaic cell and manufacturing method thereof according to the invention, based on embodiments thereof.

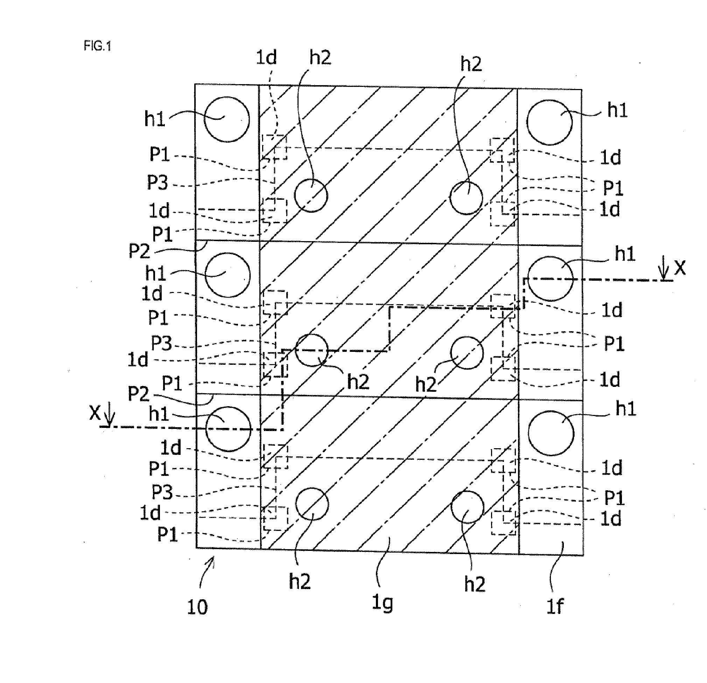

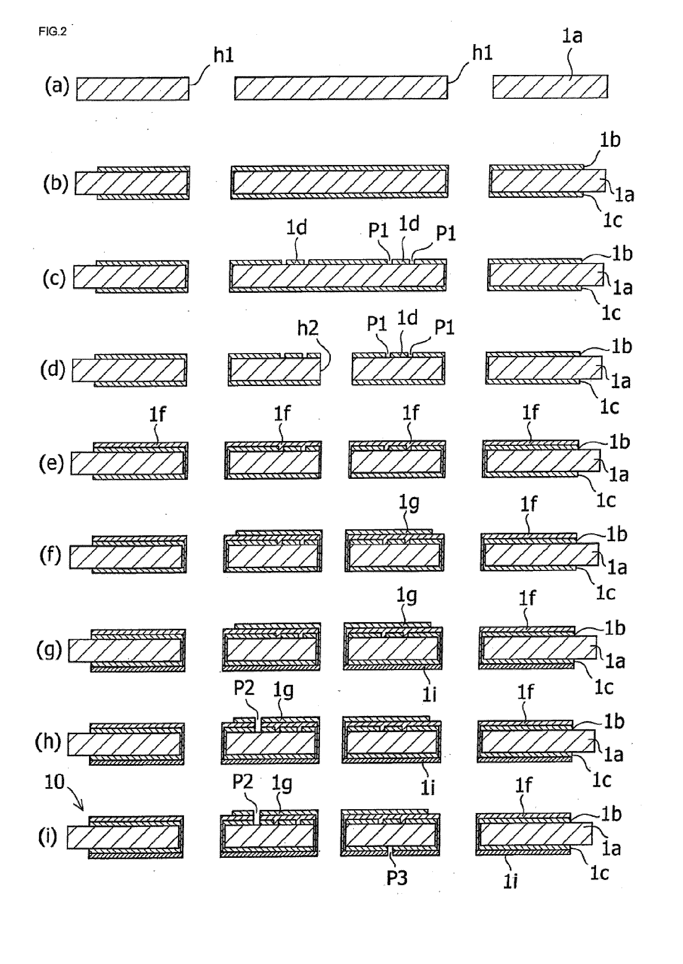

Fig. 1 shows a plan view of a thin-film photovoltaic cell according to the embodiments of the invention seen from a light receiving surface (main surface) side. Also, Figs. 2(a) to (i), showing manufacturing steps of the thin-film photovoltaic cell according to a first embodiment of the invention, are sectional views along an X-X line in Fig. 1. A thin-film photovoltaic cell 10 of this embodiment, as shown in Fig. 1 and Fig. 2, is such that a first electrode layer 1b, a photoelectric conversion layer (semiconductor layer) 1f, and a third electrode layer (transparent electrode layer) 1g are formed sequentially stacked on a main surface of a flexible substrate (polymer substrate) 1a having electrical insulation, and a second electrode layer 1c and fourth electrode layer 1i stacked on another surface on the side of the substrate 1a opposite to the main surface are formed stacked.

Characteristics of the thin-film photovoltaic cell 10 of this embodiment are that parting lines (processing lines, electrode removal portions) P3 indicated by a broken line on the rear side of the substrate 1a are not of a linear form, but have a crank form crooked structure wherein the two ends of a straight line are each bent twice in a 90° degree direction, and that the crooked portions of the parting lines P3 are outside regions bordered by parting lines (processing lines, electrode removal portions) P2 indicated by solid lines on the light receiving surface (main surface) side of the substrate 1a. That is, the thin-film photovoltaic cell 10 of this embodiment has electrically isolated regions 1d localized in the first electrode layer 1b. The regions 1d are formed by removing places in the first electrode layer 1b where there are parting lines (processing lines, electrode removal portions) P1 in portions coinciding with acceleration and deceleration regions for the parting lines P3 on the other surface side of the substrate 1a to form the crooked structure, or with intersection portions of the processing lines configuring the crooked structure.

A description will be given, using Figs. 2(a) to (i), of a manufacturing method of the thin-film photovoltaic cell 10 with this kind of structure according to this embodiment. Herein, (a) to (i) are sectional views showing steps of (a) boring first through holes h1, (b) depositing the first electrode layer 1b and second electrode layer 1c, (c) dividing the first electrode layer 1b, (d) boring second through holes h2, (e) depositing the photoelectric conversion layer 1f, (f) depositing the third electrode layer 1g, (g) depositing the fourth electrode layer 1i, (h) dividing the first electrode layer 1b, photoelectric conversion layer 1f, and third electrode layer 1g on the main surface side, and (i) dividing the second electrode layer 1c and fourth electrode layer 1i on the other surface side.
A flexible polymer substrate (a heat resistant plastic substrate such as a polyimide series, polyethylene naphthalate (PEN) series, polyethersulfone (PES) series, polyethylene terephthalate (PET) series, or aramid series film) is used as the substrate 1a of the thin-film photovoltaic cell 10 of this embodiment. Apart from this, not being limited to a flexible substrate, it is also possible to use a glass substrate, or the like.

(a) Firstly, plural connection holes (series connection holes) h1, which are the first through holes, are formed opened in predetermined positions in the substrate 1a. As a method of forming the connection holes h1, there is a method of mechanically boring the holes using a die such as a punch, a method of obtaining through holes using a laser, and the like. The form of the connection holes h1, not necessarily being circular, may be a form such as a quadrilateral or an ellipse. Also, it not being necessary that the quantity and size of the connection holes h1 are always of the values of this embodiment, the quantity may be increased or decreased, and the diameter increased or decreased, as necessary.

(b) Next, the first electrode layer 1b (this surface is taken as the front surface) is deposited on the substrate 1a, and the second electrode layer 1c is subsequently deposited on the rear surface, which is the side opposite to the first electrode layer 1b. At this time, the first electrode layer 1b and second electrode layer 1c are connected stacked on the inner surfaces of the connection holes h1, and are mutually conductive. The depositing of the first electrode layer 1b and second electrode layer 1c may be carried out in reverse order.
   An Ag target, or the like, being used as these electrode layers, Ag is formed to a thickness of several hundred nanometers using a sputtering device. Also, a textured form is formed on the surface of the first electrode layer 1b in order to scatter incident light, thus increasing the absorption amount of a photoelectric conversion element. Not only an Ag electrode, but a material that forms an optimum textured form may be applied as the first electrode layer 1b, for example, it may be a laminated film wherein plasma-resistant TiO₂ is deposited on the surface of an Ag electrode, SnO₂, ZnO, or the like.

(c) The electrically isolated regions 1d are formed in the first electrode layer 1b by the parting lines (electrode removal portions) P1 in portions coinciding with acceleration and deceleration regions for the parting lines (electrode removal portions) P3 on the other surface side positioned on the side opposite to the main surface of the substrate 1a to form the crooked structure, or with intersection portions of the processing lines configuring the crooked structure. The parting lines P1 are formed by removing the first electrode layer 1b with a laser patterning device.
   The processing positions of the isolated regions 1d can be decided from the relationship between the position in the drawings of the crooked structure and the connection holes h1 in a subsequent step of removing the electrodes on the other surface side, but it is good to decide taking into consideration line width, processing position accuracy, and the like, when processing the electrodes on the other surface side in the subsequent step. Also, it not being essential that the processing form of the isolated regions 1d is quadrilateral, as in this embodiment, they may be of any form, such as circular. Meanwhile, the parting line P1 processing method may be a method other than a laser patterning, for example, the processing may be carried out by a process using an ultrasonic transducer or sandblasting.

(d) Next, the plural current collection holes h2, which are the second through holes, are formed opened, again in predetermined positions in the substrate 1a. The current collection holes h2 are circular, with a diameter in the order of 1mm, and are mechanically bored with a punch. As with the connection holes h1, it not being necessary that the form, size, quantity, and the like, of the current collection holes h2 are always of the values of this embodiment, they may be changed as necessary.
The step order of the steps (c) and (d) may be reversed.

(e) After passing through this kind of step, the photoelectric conversion layer 1f, which is a thin-film semiconductor layer, is deposited. A two-layer tandem structure of amorphous silicon (a-Si) and amorphous silicon germanium (a-SiGe) is used as the photoelectric conversion layer 1f of this embodiment. Apart from these, amorphous silicon carbide (a-SiC), amorphous silicon oxide (a-SiO), amorphous silicon nitride (a-SiN), microcrystal silicon (µc-Si), microcrystal silicon germanium (µc-SiGe), microcrystal silicon carbide (µc-SiC), microcrystal silicon oxide (µc-SiO), microcrystal silicon nitride (µc-SiN), or the like, may be applied as the material of the photoelectric conversion layer 1f. Although a plasma CVD method is applied on this occasion as a method of depositing each layer of the photoelectric conversion layer 1f, it is also possible to carry out the deposition using, for example, a sputtering method, a vapor deposition method, a Cat-CVD method, a photo CVD method, or the like.
   Because of this, the parting lines P1, which are removed portions of the first electrode layer 1b, for forming the locally electrically isolated regions 1d on the first electrode layer 1b are filled with the material of the photoelectric conversion layer 1f. As the photoelectric conversion layer 1f essentially forms an insulator, the first electrode layer 1b and locally electrically isolated regions 1d are electrically isolated.

(f) After the formation of the photoelectric conversion layer 1f, the third electrode layer 1g, which is a transparent electrode film, is formed using a sputtering method. In this embodiment, an ITO film is applied as the third electrode layer 1g, but a conductive oxide film of SnO2 or ZnO, or the like, may also be applied. Also, when forming the third electrode layer 1g, the film is prevented from being formed in the portions of the connection holes h1 formed at the beginning by covering peripheral portions of the connection holes h1 with a mask, or the like.

(g) Next, the fourth electrode layer 1i, which is a connection electrode layer formed from a low resistance conductive film, such as a metal film, is deposited on the rear surface of the substrate 1a on the side opposite to the surface on which the third electrode layer 1g is formed. By this step, the third electrode layer 1g and fourth electrode layer 1i are stacked on the inner surfaces of the current collection holes h2, and it is possible to cause them to be mutually conductive.

(h) Then, by removing the first electrode layer 1b, photoelectric conversion layer 1f, and third electrode layer 1g using a laser processing, the parting lines (electrode removal portions) P2 that segregate into plural cells are formed. Herein, the form of the parting lines P2, not always needing to be the kind of linear form of this embodiment, may be a form including a curved line.

(i) Finally, by removing the second electrode layer 1c and fourth electrode layer 1i using a laser processing, the parting lines (electrode removal portions) P3 are formed. The forms of the parting lines are such that the parting lines P2 are taken to be of a linear form, and the parting lines P3 are of a form bent twice at 90° at places corresponding to the regions 1d electrically isolated by the parting lines P1 in the first electrode layer 1b. The parting lines P1 form a substrate 1a main surface side under electrode pattern, the parting lines P2 form a substrate 1a main surface side separation pattern, and the parting lines P3 form a substrate 1a other surface side separation pattern.
The step order of the steps (h) and (i) may be reversed.

In this way, as the thin-film photovoltaic cell 10 of the embodiments of the invention has the regions 1d locally electrically isolated from the first electrode layer 1b, formed before stacking the photoelectric conversion layer 1f and third electrode layer 1g, in the first electrode layer 1b, even supposing that crystallization or damage due to a laser processing, or the like, occurs in portions coinciding with acceleration and deceleration regions for the parting lines P3 on the other surface side of the substrate 1a to form the crooked structure, or with intersection portions of the processing lines configuring the crooked structure, the existence of the relevant isolated region 1d means that it does not happen that a leak path is formed by the first electrode layer 1b and second electrode layer 1c becoming continuous. Consequently, the thin-film photovoltaic cell 10 of this embodiment is a highly efficient thin-film photovoltaic cell, and has superior commercial value.

Also, as the manufacturing method of the thin-film photovoltaic cell 10 according to the first embodiment of the invention passes through the heretofore described manufacturing steps (a) to (i), it is possible to stably obtain a highly efficient thin-film photovoltaic cell with which it is possible to change output voltage and current in accordance with needs, without reducing mass productivity.

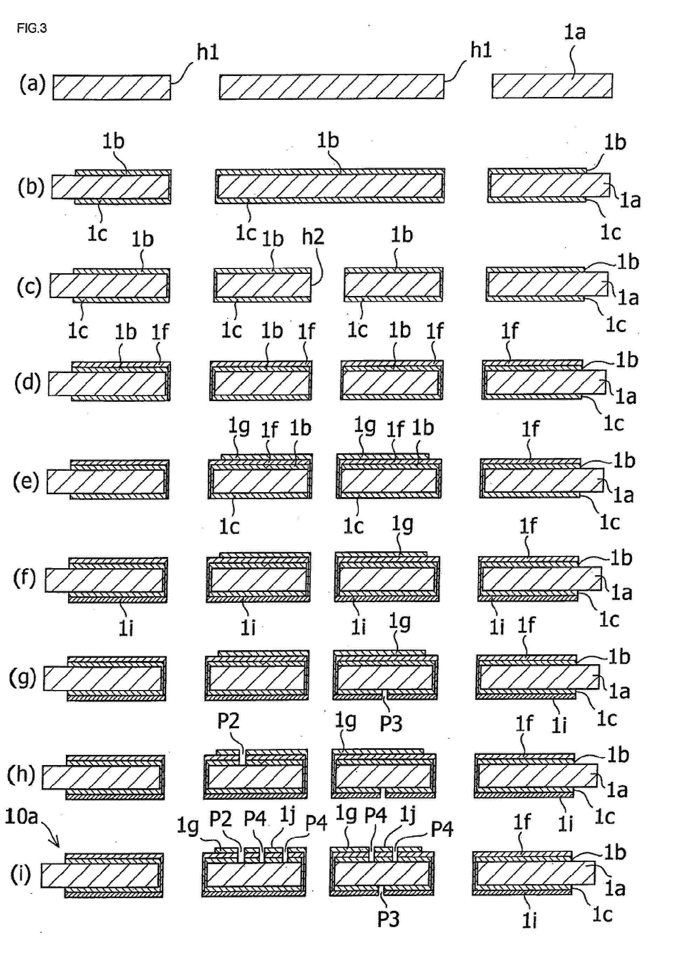

Figs. 3 (a) to (i), showing manufacturing steps of a thin-film photovoltaic cell according to a second embodiment of the invention, are sectional views along the X-X line in Fig. 1.
A point that a thin-film photovoltaic cell 10a of this embodiment has locally electrically isolated regions 1j in the first electrode layer 1b, photoelectric conversion layer 1f, and third electrode layer 1g differs from the thin-film photovoltaic cell 10 of the heretofore described embodiment. The regions 1j are formed by removing places in the first electrode layer 1b, photoelectric conversion layer 1f, and third electrode layer 1g where there are parting lines P4 in portions coinciding with acceleration and deceleration regions for the parting lines P3 on the other surface side of the substrate 1a to form the crooked structure, or with intersection portions of the processing lines configuring the crooked structure.
As configurations other than this are the same as in the heretofore described embodiment, the same reference numerals and signs are given to members the same as those in the heretofore described embodiment, and a description is omitted.

A description will be given, using Figs. 3(a) to (i), of a manufacturing method of the thin-film photovoltaic cell 10a with this kind of structure according to this embodiment. Herein, (a) to (i) are sectional views showing steps of (a) boring the first through holes h1, (b) depositing the first electrode layer 1b and second electrode layer 1c, (c) boring the second through holes h2, (d) depositing the photoelectric conversion layer 1f, (e) depositing the third electrode layer 1g, (f) depositing the fourth electrode layer 1i, (g) dividing the second electrode layer 1c and fourth electrode layer 1i on the other surface side, (h) dividing the first electrode layer 1b, photoelectric conversion layer 1f, and third electrode layer 1g on the main surface side, and (i) dividing other places in the first electrode layer 1b, photoelectric conversion layer 1f, and third electrode layer 1g on the main surface side.

(a) The same as (a) of the first embodiment.
(b) The same as (b) of the first embodiment.
(c) The same as (d) of the first embodiment.

(d) After passing through this kind of step, the photoelectric conversion layer 1f, which is a thin-film semiconductor layer, is deposited. A two-layer tandem structure of amorphous silicon (a-Si) and amorphous silicon germanium (a-SiGe) is used as the photoelectric conversion layer 1f of this embodiment. Apart from these, amorphous silicon carbide (a-SiC), amorphous silicon oxide (a-SiO), amorphous silicon nitride (a-SiN), microcrystal silicon (µc-Si), microcrystal silicon germanium (µc-SiGe), microcrystal silicon carbide (µc-SiC), microcrystal silicon oxide (µc-SiO), microcrystal silicon nitride (µc-SiN), or the like, may be applied as the material of the photoelectric conversion layer 1f. Although a plasma CVD method is applied on this occasion as a method of depositing each layer of the photoelectric conversion layer 1f, it is also possible to carry out the deposition using, for example, a sputtering method, a vapor deposition method, a Cat-CVD method, a photo CVD method, or the like.

(e) The same as (f) of the first embodiment.
(f) The same as (g) of the first embodiment.
(g) Next, by removing the second electrode layer 1c and fourth electrode layer 1i using a laser processing, the parting lines P3 are formed. The form of the parting lines P3 is a form bent twice at 90°.
(h) The same as (h) of the first embodiment.

(i) Finally, after forming the processed portions on the other surface side of the substrate 1a, parting lines P4 are formed by removing predetermined places in the first electrode layer 1b, photoelectric conversion layer 1f, and third electrode layer 1g using a laser processing, in such a way as to include acceleration and deceleration regions for forming the crooked structure of the other surface side processed portions or intersection portions of the processing lines configuring the crooked structure, thus forming the regions 1j locally electrically isolated from the first electrode layer 1b, photoelectric conversion layer 1f, and third electrode layer 1g.

According to the thin-film photovoltaic cell 10a and manufacturing method thereof of the second embodiment of the invention, it is possible to obtain the same advantage as with the thin-film photovoltaic cell 10 of the first embodiment, and it is possible to manufacture with the configuration of the thin-film photovoltaic cell shown in Fig. 3.

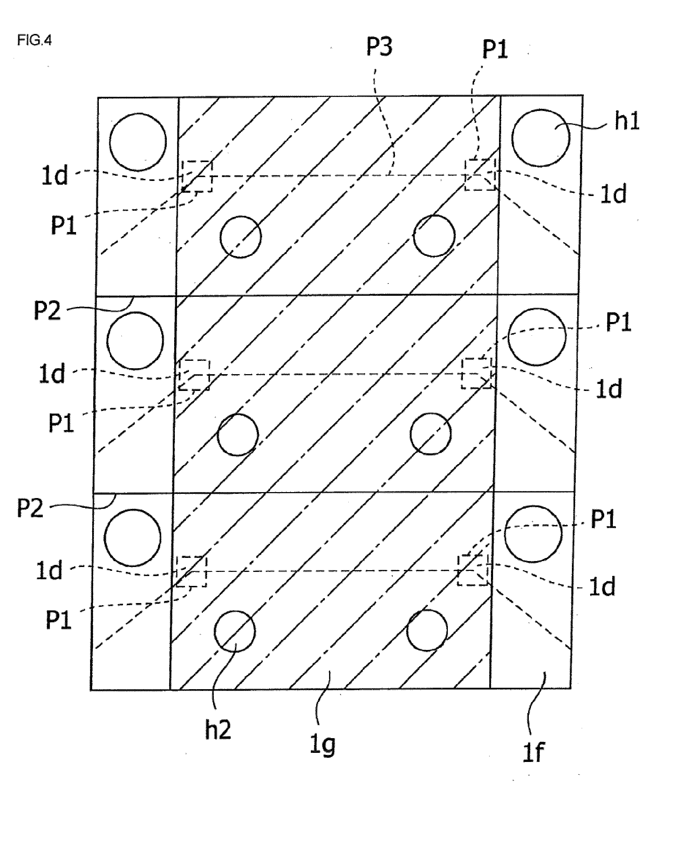

Heretofore, a description has been given of embodiments of the invention but, the invention not being limited to the embodiments already described, various kinds of change and alteration are possible based on the technological idea of the invention.
For example, the invention not being limited to the crooked structure of the parting lines P3 of the embodiment shown in Fig. 1, it is also possible to adopt a crooked structure of the parting lines P3 wherein either end of a linear form is slanted at an obtuse angle, as shown in Fig. 4. Because of this, it is possible to manufacture a thin-film photovoltaic cell having various output voltages and currents compliant with needs.

### Description of Reference Numerals and Signs

| | |
|---|---|
| 1a | Substrate |
| 1b | First electrode layer |
| 1c | Second electrode layer |
| 1f | Photoelectric conversion layer (semiconductor layer) |
| 1g | Third electrode layer (transparent electrode layer) |
| 1i | Fourth electrode layer |
| 10, 10a | Thin-film photovoltaic cell |
| h1 | Connection hole (first through hole) |
| h2 | Current collection hole (second through hole) |
| P1, P2, P4 | Main surface side parting line (processing line) |
| P3 | Other surface side parting line (processing line) |

## Claims

1. A thin-film photovoltaic cell, wherein a serially connected structure is formed by a plurality of unit photovoltaic cells, wherein a first electrode layer, a semiconductor layer that is a photoelectric conversion layer, and a transparent third electrode layer are sequentially stacked on a main surface of an insulating substrate, a second electrode layer and a fourth electrode layer are formed on another surface of the substrate, and the third electrode layer is connected to the second electrode layer and fourth electrode layer, by a conductor essentially isolated from the first electrode layer, via one or more second through holes that penetrate the substrate, first electrode layer, second electrode layer, and semiconductor layer, being formed on a common substrate, adjacent unit photovoltaic cells being electrically isolated by a main surface side processed portion in which the first electrode layer, semiconductor layer, and third electrode layer are removed, and by an other surface side processed portion in which the second electrode layer and fourth electrode layer are removed, and an extension portion of the first electrode layer of one unit photovoltaic cell being connected to an extension portion of the second electrode layer of an adjacent unit photovoltaic cell, by a conductor essentially isolated from the third electrode layer of the unit photovoltaic cell, via one or more first through holes that penetrate the substrate, the thin-film photovoltaic cell being **characterized in that**
the other surface side processed portion has a crooked structure, and acceleration and deceleration regions for forming the crooked structure of the other surface side processed portion, or intersection portions of processing lines configuring the crooked structure, are disposed in locally electrically isolated regions in the first electrode layer before the formation of the semiconductor layer.

2. A thin-film photovoltaic cell, wherein a serially connected structure is formed by a plurality of unit photovoltaic cells, wherein a first electrode layer, a semiconductor layer that is a photoelectric conversion layer, and a transparent third electrode layer are sequentially stacked on a main surface of an insulating substrate, a second electrode layer and a fourth electrode layer are formed on another surface of the substrate, and the third electrode layer is connected to the second electrode layer and fourth electrode layer, by a conductor essentially isolated from the first electrode layer, via one or more second through holes that penetrate the substrate, first electrode layer, second electrode layer, and semiconductor layer, being formed on a common substrate, adjacent unit photovoltaic cells being electrically isolated by a main surface side processed portion in which the first electrode layer, semiconductor layer, and third electrode layer are removed, and by an other surface side processed portion in which the second electrode layer and fourth electrode layer are removed, and an extension portion of the first electrode layer of one unit photovoltaic cell being connected to an extension portion of the second electrode layer of an adjacent unit photovoltaic cell, by a conductor essentially isolated from the third electrode layer of the unit photovoltaic cell, via one or more first through holes that penetrate the substrate, the thin-film photovoltaic cell being **characterized in that**
the other surface side processed portion has a crooked structure, and acceleration and deceleration regions for forming the crooked structure of the other surface side processed portion, or intersection portions of processing lines configuring the crooked structure, are disposed in locally electrically isolated regions from which the first electrode layer, semiconductor layer, and third electrode layer are removed.

3. The thin-film photovoltaic cell according to claim 1 or 2, **characterized in that** the processing lines have a form such that they are bent twice at 90° in places corresponding to the electrically isolated regions in the first electrode layer.

4. The thin-film photovoltaic cell according to claim 1 or 2, **characterized in that** the processing lines have a form such that they are slanted at an obtuse angle in places corresponding to the electrically isolated regions in the first electrode layer.

5. A thin-film photovoltaic cell manufacturing method, whereby a serially connected structure is formed by a plurality of unit photovoltaic cells, wherein a first electrode layer, a semiconductor layer that is a photoelectric conversion layer, and a transparent third electrode layer are sequentially stacked on a main surface of an insulating substrate, a second electrode layer and a fourth electrode layer are formed on another surface of the substrate, and the third electrode layer is connected to the second electrode layer and fourth electrode layer, by a conductor essentially isolated from the first electrode layer, via one or more second through holes that penetrate the substrate, first electrode layer, second electrode layer, and semiconductor layer, being formed on a common substrate, adjacent unit photovoltaic cells being electrically isolated by a main surface side processed portion in which the first electrode layer, semiconductor layer, and third electrode layer are removed, and by an other surface side processed portion in which the second electrode layer and fourth electrode layer are removed, and an extension portion of the first electrode layer of one unit photovoltaic cell being connected to an extension portion of the second electrode layer of an adjacent unit photovoltaic cell, by a conductor essentially isolated from the third electrode layer of the unit photovoltaic cell, via one or more first through holes that penetrate the substrate, the thin-film photovoltaic cell manufacturing method being **characterized in that**
before the semiconductor layer is formed on the first electrode layer, locally electrically isolated regions are formed in the first electrode layer by removing the first electrode layer, after which, the main surface side processed portion is formed by removing the first electrode layer, semiconductor layer, and third electrode layer, the other surface side processed portion is formed by removing the second electrode layer and fourth electrode layer, and acceleration and deceleration regions for forming a crooked structure of the other surface side processed portion, or intersection portions of processing lines configuring the crooked structure, are disposed in the electrically isolated regions.

6. A thin-film photovoltaic cell manufacturing method, whereby a serially connected structure is formed by a plurality of unit photovoltaic cells, wherein a first electrode layer, a semiconductor layer that is a photoelectric conversion layer, and a transparent third electrode layer are sequentially stacked on a main surface of an insulating substrate, a second electrode layer and a fourth electrode layer are formed on another surface of the substrate, and the third electrode layer is connected to the second electrode layer and fourth electrode layer, by a conductor essentially isolated from the first electrode layer, via one or more second through holes that penetrate the substrate, first electrode layer, second electrode layer, and semiconductor layer, being formed on a common substrate, adjacent unit photovoltaic cells being electrically isolated by a main surface side processed portion in which the first electrode layer, semiconductor layer, and third electrode layer are removed, and by an other surface side processed portion in which the second electrode layer and fourth electrode layer are removed, and an extension portion of the first electrode layer of one unit photovoltaic cell being connected to an extension portion of the second electrode layer of an adjacent unit photovoltaic cell, by a conductor essentially isolated from the third electrode layer of the unit photovoltaic cell, via one or more first through holes that penetrate the substrate, the thin-film photovoltaic cell manufacturing method being **characterized in that**
after stacking the semiconductor layer and third electrode layer, and forming the other surface side processed portion by removing the second electrode layer and fourth electrode layer, there are formed regions locally electrically isolated by the main surface side processed portion from which the first electrode layer, semiconductor layer, and third electrode layer are removed, and acceleration and deceleration regions for forming a crooked structure of the other surface side processed portion, or intersection portions of processing lines configuring the crooked structure, are disposed in the electrically isolated regions.

7. The thin-film photovoltaic cell manufacturing method according to claim 5 or 6, **characterized in that** the processing lines have a form such that they are bent twice at 90° in places corresponding to the electrically isolated regions in the first electrode layer.

8. The thin-film photovoltaic cell manufacturing method according to claim 5 or 6, **characterized in that** the processing lines have a form such that they are slanted at an obtuse angle in places corresponding to the electrically isolated regions in the first electrode layer.
